# EUROPEAN PATENT APPLICATION

(11) **EP 2 161 746 A1**
(43) Date of publication of application: **10.03.2010**
(21) Application number: 08015771.2
(22) Date of filing: 08.09.2008
(51) Int. Cl.: H01L 23/48, H01L 29/744

(54) **Semiconductor switching devices**

(71) Applicant: Converteam Technology Ltd, Rugby Warwickshire CV21 1BU (GB)
(72) Inventor: Crane, Allan David, Clifton upon Dunsmore Rugby Warwickshire CV23 0BH (GB); Newton, Christopher, Dr., Rugby Warwickshire CV23 0UN (GB); Hinchley, David, Dr., South Kilworth Lutterworth LE17 6ED (GB)
(74) Representative: Thacker, Darran Ainsley

(57) **Abstract**

The present invention provides a semiconductor switching device (e.g. a gate turn-off thyristor (GTO)). The semiconductor switching device includes a suitable semiconductor substrate (42) having a cathode electrode and a gate electrode. A cathode plate (44) such as a molybdenum disc is in contact with the cathode electrode. The semiconductor switching device is controlled by a gate drive circuit that is preferably mounted external to any housing. A gate drive connection (54) includes a gate connector (56) in electrical contact with the gate electrode and an auxiliary cathode connector (58) in electrical contact with the cathode plate. A laminated strip conductor (laminated busbar 78) has a first conductor element (68) along which a gate current can flow from the gate drive circuit to the gate connector (56), a second conductor element (72) along which an auxiliary cathode current can flow from the auxiliary cathode connector (58) to the gate drive circuit and a dielectric layer (76) between the first conductor element and the second conductor element. The semiconductor switching device has a very low gate drive inductance.

## Description

### Technical Field

The present invention relates to semiconductor switching devices, and in particular to gate turn-off thyristors (GTOs) having an improved gate drive connection.

### Background Art

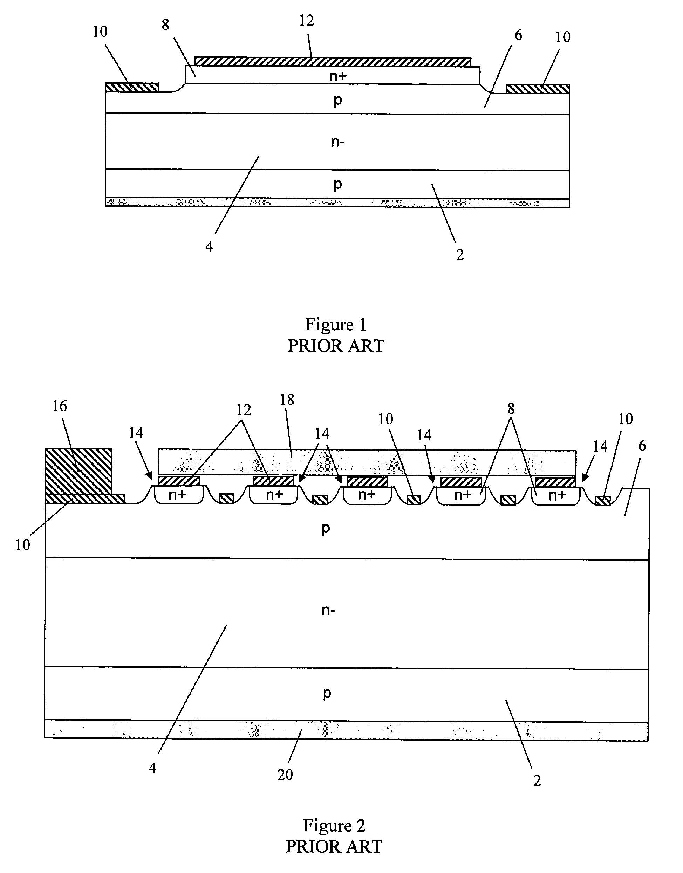

Gate turn-off thyristors (GTOs) are well known semiconductor switching devices. They are often formed from a large number of integrated individual thyristors with four-layer pnpn structures connected in parallel. An example of an individual thyristor is shown in Figure 1 and includes a p type anode layer 2, an n- type (i.e. lightly doped) base layer 4, a p type base layer 6 and an n+ type (i.e. highly doped) cathode layer 8. A metal layer is provided on an outer surface of the p type base layer 6 to form a gate electrode 10. A metal layer is also provided on an outer surface of the cathode layer 8 to form a cathode electrode 12.

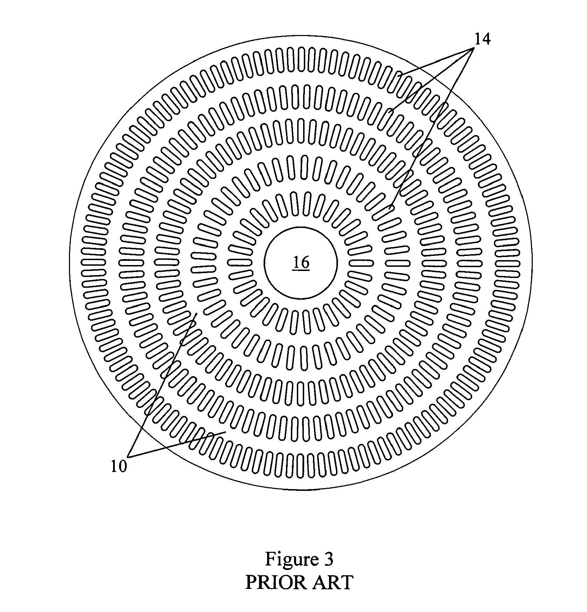

Part of a typical GTO in which a number of individual thyristors are integrated in parallel is shown in Figure 2. The thyristors have a common p type anode layer 2, a common n- type base layer 4, a common p type base layer 6 and an individual n+ type cathode layer 8. More particularly, the cathode layer of the GTO may be defined by a plurality of individual raised mesas 14 (sometimes called mesa emitters) that are commonly arranged as a series of concentric rings, as shown in Figure 3. An outer surface of the common p type base layer 6 is covered with a continuous metal layer to form a gate electrode 10 that effectively surrounds the raised mesas 14 of the cathode layer. A central gate contact 16 is provided on the gate electrode 10. Outer surfaces of the individual raised mesas 14 are themselves covered with a metal layer to form a plurality of individual cathode electrodes 12.

A cathode plate 18 contacts the individual cathode electrodes 12. To prevent the semiconductor layers from being cracked by thermal distortion, it is often preferred that the cathode plate 18 is formed of a material such as molybdenum or tungsten which has a coefficient of thermal expansion similar to that of the semiconductor material that is used to form the anode, base and cathode layers.

A similar anode plate 20 contacts an outer surface of the common anode layer 2.

In a conventional press pack construction, the semiconductor layers, cathode plate and anode plate are pressed between a pair of outer pole pieces. An example of a conventional press pack construction is shown in United States Patent 6441407. More particularly, Figures 2c and 3a of United States Patent 6441407 show a perspective view of a GTO 33 in which a semiconductor substrate 31 is arranged between cathode and anode plates 32 and hermetically sealed in an insulating housing 30. The semiconductor substrate 31 and the cathode and anode plates 32 are pressed between an anode pole piece 33 and a cathode pole piece 34.

It will be readily appreciated that a gate drive connection must be made to the gate electrode to enable the individual thyristors to be turned on and off by an external gate drive circuit. Several different gate drive connections have been proposed, but they all have certain technical disadvantages. There is therefore a need for a semiconductor switching device having an improved gate drive connection.

For a conventional GTO, variations in device geometry and processing mean that all of the individual thyristors do not switch simultaneously. During turn-off, this leads to very high current densities in the last thyristors to remain on. The non-uniform turn-off restricts the GTO current ratings and necessitates the use of snubber circuits to reduce the stress on the device.

In order to achieve uniform turn-off in a GTO, and thus eliminate the need for snubber circuits, it is necessary to "hard-switch" the device. Hard-switching entails the use of a very high gate current di/dt that rises to a peak value in excess of the anode current. This forces the GTO to unlatch and the turn-off mode is akin to that of an open-base bipolar junction transistor (BJT). A GTO that is specifically designed for hard-switching is commonly known as a gate commutated thyristor or a gate controlled thyristor (GCT).

Achieving a very high gate current di/dt with a finite gate voltage requires a very low value of gate drive inductance. For example, for a GCT having a rating of 3000A to achieve a typical turn-off di/dt of 3000A/µs with a gate voltage of 15V would require a gate drive inductance of less than 5nH. In comparison, a standard GTO having a twin-lead gate-cathode connection has a typical gate drive inductance of 300nH. A GCT must therefore employ a radically different gate drive topology.

One way of reducing the gate drive inductance is to integrate the whole of the gate drive (i.e. both the gate drive circuit and the gate drive connection) into the press pack. Such an arrangement is disclosed in United States Patent 5027192. However, standard gate drive circuit components are not rated for the elevated temperatures that are experienced inside the press pack and the approach has been criticised on the basis of high cost and low reliability ("High-power hard-driven GTO module for snubberless operation" H Grunning et al., PCIM 1996 Conference).

Another option is to integrate only key components of the gate drive circuit (such as capacitors and switching devices) into the press pack ("Optimized gate drivers for internally commutated thyristors (ICTs)" P Kollensperger, R De Doncker, IEEE Industrial Applications Conference, 2006). However, in common with the fully-integrated solution mentioned above, the reliability of the gate drive circuit components within the press pack will be severely compromised by elevated temperatures.

Consequently, the option that is currently preferred is to use a gate drive circuit that is external to the press pack or housing but with a low inductance gate drive connection. Such arrangements are disclosed in United States Patents 5345096, 6072200, 6323547, 6423988 and 6441407.

United States Patent 6441407 represents the preferred embodiment currently employed in commercial hard-switched GTOs. With reference to Figure 3a, an annular gate connection 35 surrounds the housing 30 and defines a gate electrode flange extending radially from the housing. Screw holes 35' are arranged around the circumference of the gate connection flange. An auxiliary cathode connection 36 defines an auxiliary cathode flange that extends radially from the cathode pole piece 34 and lies parallel to the gate electrode flange. Screw holes 36' are arranged around the circumference of the auxiliary cathode flange aligned with the screw holes 35' in the gate connection flange. A printed circuit board (PCB) for the gate drive circuit is located between the gate connection flange and the auxiliary cathode flange. The arrangement provides a low inductance gate drive connection that is external to the housing 30. However, the internal inductance is still significant due to the lack of close coupling between the gate connection flange and the auxiliary cathode flange within the housing itself. Consequently, the overall gate drive inductance is still high and it is necessary to employ a high value of gate drive capacitance. This requires the use of electrolytic capacitors, which have a high failure rate and severely limit the reliability of the GTO.

### Summary of the Invention

The present invention seeks to overcome some of the problems mentioned above by providing a semiconductor switching device that has a very low gate drive inductance. More particularly, the present invention provides a semiconductor switching device comprising:
a semiconductor body having a cathode electrode and a gate electrode;
a cathode plate in contact with the cathode electrode;
a gate drive circuit; and
a gate drive connection having:
   a gate connector in electrical contact with the gate electrode;
   an auxiliary cathode connector in electrical contact with the cathode plate; and
   a laminated strip conductor comprising a first conductor element along which a gate current can flow from the gate drive circuit to the gate connector, a second conductor element along which an auxiliary cathode current can flow from the auxiliary cathode connector to the gate drive circuit, and a dielectric layer between the first conductor element and the second conductor element.

The semiconductor body may have any suitable topology. For example, in the case where the semiconductor switching device is a gate turn-off thyristor (GTO) then the semiconductor body may have an anode layer, two base layers and a cathode layer defined by a plurality of raised mesas (i.e. mesa emitters). The cathode electrode may be formed on the outer surfaces of the raised mesas and the gate electrode may be formed on an outer surface of the at least one base layer between the raised mesas of the cathode layer. The semiconductor switching device may be specifically designed for hard-switching and gate commutated thyristors or gate controlled thyristors (GCT) are therefore considered to be within the scope of the present invention. Other suitable topologies may include those with buried gate and other coplanar contact structures that may be used in a variety of semiconductor switching devices such as insulated-gate bipolar transistors (IGBTs), for example. These semiconductor switching devices may be symmetrical reverse blocking or asymmetrically types.

The semiconductor switching device will normally include a cathode power terminal and an anode power terminal.

The semiconductor switching device preferably further comprises an anode plate in contact with an anode layer of the semiconductor body.

Each of the first and second conductor elements of the laminated strip conductor (laminated busbar) preferably takes the form of one or more thin strips of electrically conductive material such as copper. The first and second conductor elements are physically joined together by a thin dielectric layer such as polyimide and are therefore closely coupled along a significant proportion of their length. The first conductor element defines a "go path" along which gate current can flow from the gate drive circuit to the gate connector and hence to the gate electrode, while the second conductor element defines a "return path" along which auxiliary cathode current can flow from the cathode electrode through the cathode plate and the auxiliary cathode connector to the gate drive circuit.

The gate connector preferably includes a pressure contact member and an annular contact ring that is pressed into contact with the gate electrode. Similarly, the auxiliary cathode connector preferably includes a pressure contact member and an annular contact ring that is pressed into contact with the cathode plate. The pressure contact members and the annular contact rings may be formed of any suitable electrically conductive material. The annular contact rings may be adapted to be deformable under the contact pressure applied by the associated pressure contact member.

The gate connector is preferably coaxially located within the auxiliary cathode connector. The pressure contact members may be spaced apart by a dielectric layer such as polyimide.

The gate connector will preferably extend through an aperture provided in the cathode plate so that the associated annular contact ring can be pressed into contact with the gate electrode. Where appropriate for the particular semiconductor body, the region of the gate electrode that is in contact with the annular contact ring will normally be free from the raised mesas that define the cathode layer. In other words, there should be no electrical contact between the gate connector and either the cathode electrode or the cathode plate. The annular contact ring of the auxiliary cathode connector may be pressed into contact with a region of the cathode plate that borders or surrounds the aperture through which the gate connector passes.

The first conductor element of the laminated strip conductor is preferably fixed to an outer surface of the pressure contact member of the gate connector and may optionally extend at least partially around its periphery. The first conductor element of the laminated strip conductor preferably extends through a slot or opening provided in the pressure contact member of the auxiliary cathode connector.

The second conductor element of the laminated strip conductor is preferably fixed to an outer surface of the pressure contact member of the auxiliary cathode connector and may optionally extend at least partially around its periphery.

In an alternative arrangement, the auxiliary cathode connector can be formed by a cathode side pole piece of the semiconductor switching device. The cathode side pole piece may be further defined by a housing part that is pressed into contact with the cathode plate, for example. The second conductor element of the laminated strip conductor can be fixed to an inner surface of the cathode side pole piece.

The various electronic components of the gate drive circuit (e.g. MOSFETs, multilayer ceramic capacitors etc.) will normally be mounted on a printed circuit board (PCB). The PCB will normally be located external to any housing for the semiconductor switching device so that the electronic components are not exposed to elevated temperatures.

The laminated strip conductor preferably extends substantially radially outwardly from the gate and auxiliary cathode connectors.

The laminated strip conductor is preferably flexible so that it can be twisted along its length. For example, a first part of the laminated strip conductor can be fitted in a narrow slot provided in a housing and a second part can be twisted by substantially 90 degrees relative to the first part so that the free end of the laminated strip conductor can be easily and conveniently connected to a PCB on which the electrical components of the gate drive circuit are mounted. A laminated strip conductor that is rigid or semi-rigid can also be twisted in the same manner as long as its physical integrity is maintained.

The semiconductor switching device preferably includes some sort of housing having an aperture or opening for receiving the gate and auxiliary cathode connectors and a slot for receiving the laminated strip conductor.

The slot preferably extends substantially radially outwardly from the aperture or opening in the housing.

The gate drive connection (including the laminated strip conductor) may be spaced apart from the housing by a dielectric layer such as polyimide.

The shape and configuration of the housing will depend on the intended use of the semiconductor switching device. For example, if the semiconductor switching device is to have a conventional press pack construction then the housing will normally include a cathode side pole piece in which the aperture or opening is provided and an anode side pole piece. The housing will be assembled together such that the cathode plate, semiconductor body and anode plate are pressed between the pole pieces in a known manner.

If the semiconductor switching device is to have an "open" construction (optionally designed to be immersed in a liquid dielectric) then the housing will normally be a heatsink and include a plurality of cooling fins. In an "open" construction, any spaces or gaps between the various component parts of the semiconductor switching device will be filled with the liquid dielectric to provide a suitable dielectric environment. The materials used in the semiconductor switching device must be chemically, structurally and dielectrically compatible with the liquid dielectric so that neither the semiconductor switching device nor the liquid dielectric are degraded as a result of their contact. It will be readily appreciated that the "open" construction is differentiated from a conventional press pack construction because the semiconductor switching device is not hermetically sealed in a housing which allows all regions of the semiconductor body to be surrounded and permeated by a suitable moderately pressurised dielectric gas, e.g. dry nitrogen. The semiconductor switching device also lacks the copper pole pieces that are associated with conventional press pack semiconductor devices. The copper pole pieces are effectively replaced by the heatsinks. The conventional enclosure parts would normally account for about half of the total cost of the conventional press pack semiconductor device. The lack of conventional enclosure parts therefore provides significant cost benefits.

The semiconductor switching device having an "open" construction may be immersed in any suitable liquid dielectric. It will be readily appreciated that the term "liquid dielectric" is not just intended to cover proprietary liquids that are specifically marketed as such, but any liquid that has a sufficient dielectric withstand. This would include de-ionised water, FLUORINERT and other equivalent perfluorocarbon fluids, mineral transformer oils, silicone transformer oils, synthetic oils and esters, methylene chloride etc. A particularly preferred coolant fluid is a proprietary transformer insulating fluid such as MIDEL and its equivalents. Any coolant fluid will be subject to various environmental and chemical compatibility considerations.

A number of semiconductor switching devices may be arranged in axial stacks or stack assemblies, each one having a cathode side pole piece in which the aperture or opening is provided.

When operating in the hard-switching turn-off mode it is known that the gate current amplitude that is required to cause anode current turn-off is approximately linearly related to the anode current to be commutated and hence the required current rating of the gate drive connection is closely related to the anode current commutation rating and the overall size of the device. Therefore, the gate drive connection may include a plurality of laminated strip conductors, which are preferably angularly spaced about the gate and auxiliary cathode connectors. The current rating of the gate drive connection and hence the anode current commutation rating of the semiconductor switching device will be proportional to the number of laminated strip conductors. Moreover, the overall gate drive inductance will be inversely proportional to the number of laminated strip conductors. By scaling the number of laminated strip conductors in proportion with the current rating of the semiconductor switching device, the gate drive voltage required to achieve hard turn-off will remain fixed.

The first conductor element of each laminated strip conductor will preferably extend through a respective slot or opening provided in the pressure contact member of the auxiliary cathode connector. The housing will preferably have a plurality of slots, each slot receiving a respective one of the laminated strip conductors. Each laminated strip conductor may be connected to its own individual gate drive circuit to define a number of separate go and return paths. The combined current rating of the gate drive circuits is proportional to the number of gate drive circuits. A plurality of individual gate drive circuits may be provided on a single PCB.

The technical advantages of the semiconductor switching device of the present invention are a result of the fact that the go and return paths of the gate drive circuit are near symmetrical and closely magnetically coupled along substantially their entire length.

Such matching is clearly provided by the use of a laminated strip conductor where the gate and auxiliary cathode currents flow along the closely coupled first and second conductor elements, respectively. However, it will be readily appreciated that the gate and auxiliary cathode currents are also matched as they flow through the coaxially located pressure contact members and annular contact rings of the gate and auxiliary cathode connectors, respectively, and even within the axially spaced gate electrode of the semiconductor body and the cathode plate.

The physical area of the gate drive connection and the corresponding leakage inductance is reduced to the minimum practical value.

A plurality of laminated strip conductors (and hence a plurality of separate go and return paths) can be provided in parallel to reduce the leakage inductance still further.

### Drawings

Figure 1 is a cross section view of an individual thyristor;
Figure 2 is a cross section view of part of a typical gate turn-off thyristor (GTO) structure in which a number of individual thyristors are integrated in parallel;
Figure 3 is a top view of the GTO structure of Figure 2;
Figure 4 is an exploded perspective view of a GTO according to a first embodiment of the present invention having an "open" construction and designed to be immersed in a liquid dielectric;
Figure 5 is a cross section view of the assembled GTO of Figure 4;
Figure 6A is a perspective view of a gate drive connection for the GTO of Figure 4 having a single laminated busbar;
Figure 6B is a perspective view of the gate drive connection of Figure 6A on which the gate current Ig, auxiliary cathode current Ik and inductive loop area during turn-off are marked;
Figure 7 is an end view of the gate drive connection of Figure 6A inserted into a first housing part of the GTO;
Figure 8 is an exploded view of a GTO according to a second embodiment of the present invention having a press pack construction;
Figure 9 is a cross section view of the assembled GTO of Figure 8;
Figure 10 is a perspective view of a gate drive connection for the GTO of Figure 8 having a single laminated busbar;
Figure 11 is an end view of an alternative gate drive connection for a GTO according to the second embodiment of the present invention having four laminated busbars;
Figure 12 is an end view of a first alternative gate drive connection for a GTO according to the first or second embodiment of the present invention having four laminated busbars and a simplified auxiliary cathode contact; and
Figure 13 is an end view of a second alternative gate drive connection for a GTO according to the first or second embodiment of the present invention having four laminated busbars and a simplified auxiliary cathode contact.

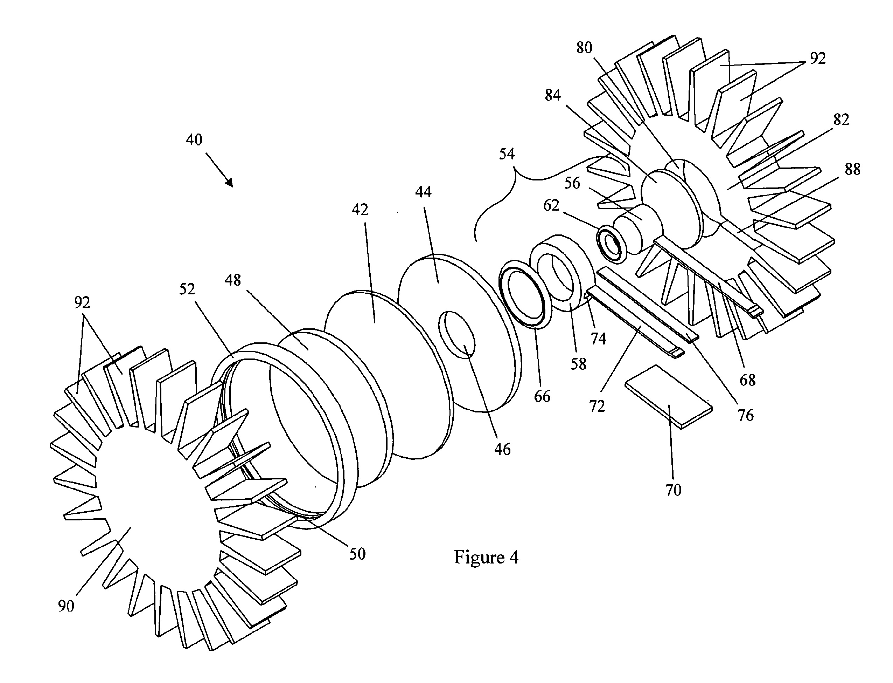

A gate turn-off thyristor (GTO) 40 according to the well known fully floating configuration, but having an "open" construction that is designed to be immersed in a liquid dielectric such as MIDEL, will now be described with reference to Figures 4 to 7. It will be readily appreciated that the basic principles described herein are equally applicable to GTOs according to the well known alloyed configuration where the semiconductor body is in permanent inter-metallic contact with the anode plate.

The GTO 40 includes a semiconductor body 42 having any suitable topology where a cathode layer is defined by a plurality of individual raised mesas. The outer surfaces of the raised mesas are covered with a metal layer to form a plurality of individual cathode electrodes. The outer surface of a base layer is covered with a continuous metal layer to form a gate electrode that effectively surrounds the raised mesas of the cathode layer.

A cathode plate 44 in the form of a molybdenum disc contacts the individual cathode electrodes of the semiconductor body 42 and is formed with a circular aperture or opening 46 at its radial centre. An anode plate 48 also in the form of a molybdenum disc contacts the outer surface of an anode layer of the semiconductor body 42.

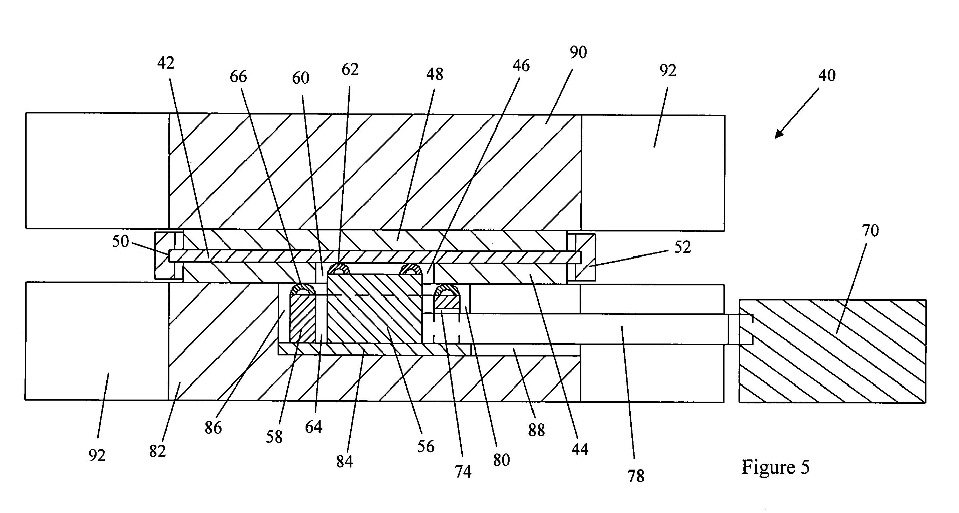

The semiconductor body 42 is securely located within an annular groove 50 that is provided in the inner cylindrical surface of an annular support 52 that surrounds the semiconductor body and the cathode and anode plates 44, 48 as shown in Figure 5.

A gate drive connection 54 includes a gate contact 56 and an auxiliary cathode contact 58.

The gate contact 56 is in the form of a solid copper cylinder that is sized to extend through the opening 46 in the cathode plate 44 as shown in Figure 5. The gate contact 56 is radially spaced apart from the cathode plate 44 by an annular gap 60 to prevent any electrical contact between them. Although not shown in Figure 5, the annular gap 60 may optionally be filled with a dielectric material.

The gate contact 56 applies an axial contact pressure to an annular contact ring 62 to press it into contact with the gate electrode of the semiconductor body 42. It will be readily appreciated that the region of the gate electrode that is contacted by the contact ring 62 must be free from the individual raised mesas that form the cathode layer.

The auxiliary cathode contact 58 is in the form of a cylindrical copper ring that is sized to surround the gate contact 56. The auxiliary cathode contact 58 is coaxially located with the gate contact 56 and is radially spaced apart from the gate contact by an annular gap 64 to prevent any electrical contact between them. Although not shown in Figure 5, the annular gap 64 may optionally be filled with a dielectric material. The auxiliary cathode contact 58 applies an axial contact pressure to an annular contact ring 66 to press it into contact with a region of the cathode plate 44 immediately surrounding the opening 46.

As shown in Figure 5, the contact rings 62, 66 are spaced apart in both the axial and radial directions.

The axial contact pressure applied by the gate contact 56 and the auxiliary cathode contact 58 may be determined by the use of a compressible insulting disc 84 that is described in more detail below. The contact rings 62, 66 may be shaped and configured in such a way as to be deformable (e.g. have an n-shaped cross section or configured according to the well known wave spring principle) against the surface of the gate electrode and the cathode plate 44, respectively.

The gate contact 56 includes a gate conductor element 68 along which a gate current can flow. The gate conductor element 68 takes the form of a thin copper strip that is about 0.3 mm thick and about 8 mm wide. A first end of the gate conductor element 68 is fixedly secured (e.g. soldered or brazed) to the outer cylindrical surface of the gate contact 56. The gate conductor element 68 extends radially outwardly from the gate contact 56 and has a free end that is adapted to be connected to a multilayer printed circuit board (PCB) 70 on which the electronic components of a gate drive circuit are mounted.

The auxiliary cathode contact 58 also includes an auxiliary cathode conductor element 72 along which an auxiliary cathode current can flow. The auxiliary cathode conductor element 72 takes the form of a thin copper strip that is about 0.3 mm thick and about 8 mm wide. A first end of the auxiliary cathode conductor element 72 is fixedly secured (e.g. soldered or brazed) to the outer cylindrical surface of the auxiliary cathode contact 58. The auxiliary cathode conductor element 72 extends radially outwardly from the auxiliary cathode contact 58 and has a free end that is adapted to be connected to the PCB 70.

The auxiliary cathode contact 58 includes a slot 74 through which the gate conductor element 68 passes. The slot 74 is formed in the auxiliary cathode contact 58 adjacent the region where the auxiliary cathode conductor element 72 is fixedly secured to the auxiliary cathode contact.

The gate and auxiliary cathode conductor elements 68, 72 are physically joined together along substantially their entire length by a strip of dielectric material 76 that is about 25 µm thick and about 8 mm wide. The gate and auxiliary cathode conductor elements 68, 72 are therefore closely coupled and together form a laminated busbar 78 that extends between the gate and auxiliary cathode contacts 56, 58 and the gate drive circuit 70.

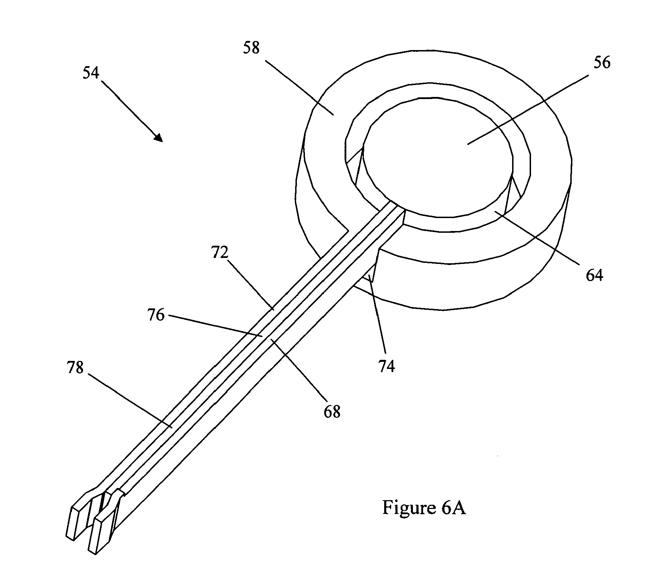

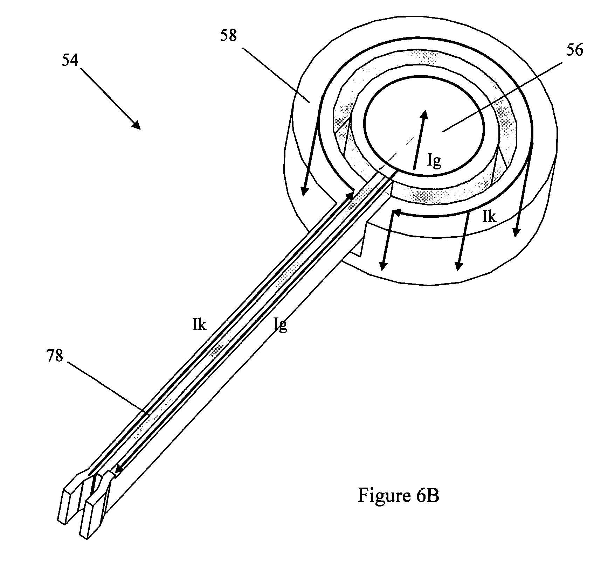

The assembled gate drive connection 54 (without the annular contact rings 62, 66) can be clearly seen in Figure 6A. The gate and auxiliary cathode conductor elements 68, 72 are physically joined to the strip of dielectric material 76 that extends through the slot 74 in the auxiliary cathode contact 58 and contacts the outer cylindrical surface of the gate contact 56. The slot 74 is sized in both the axial and circumferential directions so that the gate conductor element 68 is spaced apart from the auxiliary cathode contact 58 to prevent any electrical contact between them. Although not shown in Figures 5 and 6, the L-shaped gap between the gate conductor element 68 and the auxiliary cathode contact 58 may be filled by a dielectric material.

The free ends of the gate and auxiliary cathode conductor elements 68, 72 are slightly spaced apart to enable them to be connected to opposite planar faces of the PCB 70.

Although the GTO 40 described with reference to Figures 4 to 7 only has a single laminated busbar 78, it will be readily appreciated that two or more laminated busbars can be provided depending on the design characteristics and operating parameters of the GTO. The technical advantages of using two or more laminated busbars are described in more detail below.

The gate and auxiliary cathode contacts 56, 58 are located within an opening 80 provided in a first housing part 82 that forms a cathode side pole piece. A compressible insulating disc 84 is located between the gate and auxiliary cathode contacts 56, 58 and the bottom surface of the opening 80. In addition to axially spacing the annular faces of the gate and auxiliary cathode contacts 56, 58 from the first housing part 82, the thickness of the compressible insulating disc 84 can be selected to provide a desired axial contact pressure for the gate and auxiliary cathode contacts. In other words, increasing the thickness of the insulating disc 84 will increase the contact pressure that is applied by the gate and auxiliary cathode contacts 56, 58 to their associated annular contact ring 62, 66 and *vice versa.*

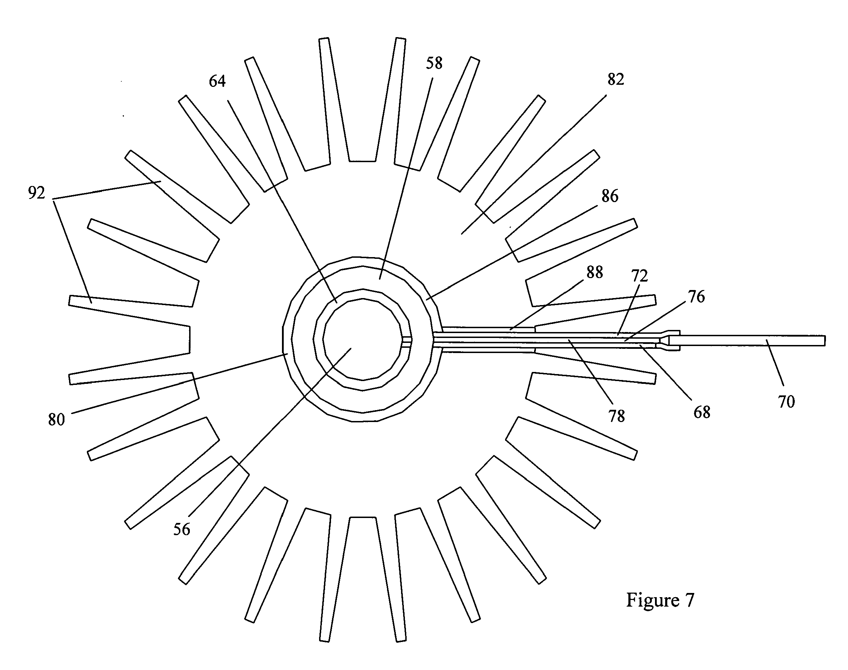

The auxiliary cathode contact 58 is radially spaced from the first housing part 82 by an annular gap 86 to prevent any electrical contact between them. Although not shown in Figures 5 and 7, the annular gap 86 may optionally be filled with a dielectric material. Cylindrical spacers of dielectric material may be provided between the auxiliary cathode contact 58 and the first housing part 82 and between the auxiliary cathode contact and the gate contact 56 to maintain the proper spacing of the gate and auxiliary cathode contacts within the opening 80 and their coaxial location.

The first housing part 82 includes a narrow slot 88 extending radially outwardly from the opening 80 to an outer surface. The laminated busbar 78 is located within the slot 88 and the free ends of the gate and auxiliary cathode conductor elements 68, 72 project beyond the first housing part 82 so that they can be connected to the PCB 70 as shown in Figure 7.

The slot 88 is sized in both the axial and circumferential directions so that the laminated busbar 78 is spaced apart from the first housing part 82 to prevent any electrical contact between them. Although not shown in Figure 7, the gaps between the laminated busbar 78 and the first housing part 82 may be filled by a dielectric material.

A second housing part 90 is also provided and forms an anode side pole piece.

The first and second housing parts 82, 90 are formed as heatsinks and are provided with a plurality of circumferentially spaced radial cooling fins 92 for dissipating the heat that is produced during the normal operation of the GTO 40 into the surrounding liquid dielectric.

Although not shown, a number of GTOs can be axially stacked together to form a stack assembly. For example, the second housing part 90 can include an opening and a slot for receiving the gate drive connection of an adjacent GTO. In this case the housing part 90 would serve as the anode side pole piece for the GTO 40 and as the cathode side pole piece for the adjacent GTO.

The turn-on and turn-off of GTOs are controlled by the gate electrode. In common with a conventional thyristor, the GTO according to the present invention is turned on by applying a positive bias voltage between the gate electrode and the cathode electrode, injecting a small forward gate current Ig. Turn off in the GTO is achieved by applying a negative bias to the gate electrode with respect to the cathode electrode, which causes a large reverse gate current Ig to flow. For a "hard-switching" GTO then the peak reverse gate current Ig is approximately equal to the anode current and the di/dt is very high. The gate and auxiliary cathode contacts 56, 58 and the laminated busbar 78 form an inductive loop. The loop inductance of the GTO gate drive circuit is a function of the loop area of the separation between the gate circuit conductor elements 68, 72 as viewed perpendicularly with respect to the surface of the semiconductor body 40 and is also a function of the width of the conductor elements, both of which are represented by the shading in Figure 6B. The gate current Ig and the auxiliary cathode current Ik during turn-off are also marked on Figure 6B. It will be readily appreciated that the gate current Ig and the auxiliary cathode current Ik will flow in the opposite direction during turn-on. In the GTO according to the present invention the loop area is minimised while the width of the conductor elements 68, 72 is maximised, and hence the gate drive inductance, is minimised.

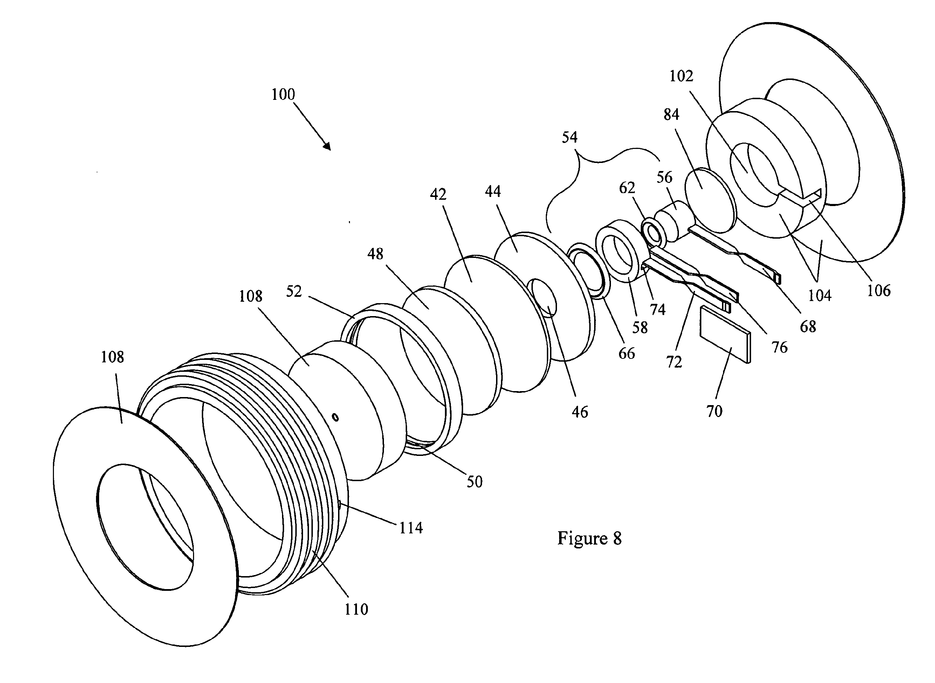

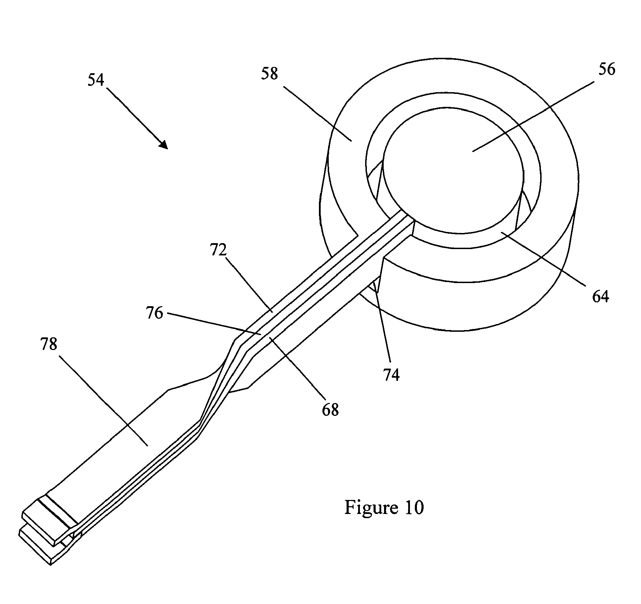

An alternative GTO 100 having a press pack construction will now be described with reference to Figures 8 to 11. Many aspects of the GTO 100 are identical to the "open" construction GTO 40 described above and like parts have been given the same reference numeral.

The main difference between the respective GTOs is the housing. In the press pack GTO 100 the gate and auxiliary cathode contacts 56, 58 are located within an opening 102 provided in a first housing part 104.

The first housing part 104 is formed as a cathode side pole piece and includes a narrow slot 106 for receiving the laminated busbar 78. The slot 106 extends radially outwardly from the opening 102 to a cylindrical surface of the first housing part. A second housing part 108 is formed as an anode side pole piece. The first and second housing parts 104, 108 are surrounded by a substantially cylindrical casing 110 and the semiconductor body 42 and the cathode and anode plates 44, 48 are compressed or clamped between the first and second housing parts in a known manner to provide a conventional press pack construction.

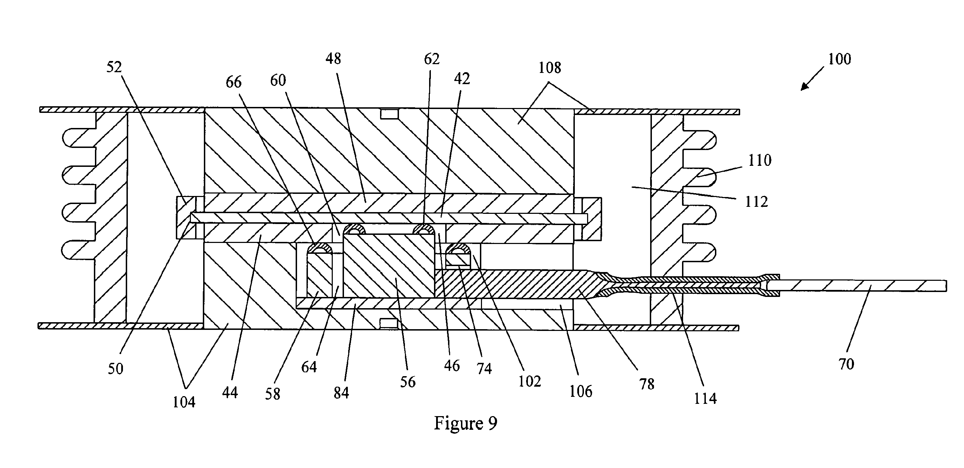

The laminated busbar 78 is flexible. A radially inner part of the laminated busbar 78 is located within the slot 106 provided in the first housing part 104 and a radially outer part of the laminated busbar is located in an annular space 112 between the first housing part and the casing 110 and is twisted relative to the radially inner part by 90 degrees such that its free end can be easily and conveniently connected to the PCB 70. It will be readily appreciated that the same effect could also be obtained by twisting a laminated busbar that is not flexible but is rigid or semi-rigid. The radially outer part of the laminated busbar 78 extends through a slot or opening 114 in the casing 110 as shown in Figure 9.

The slot 106 is sized in both the axial and circumferential directions so that the laminated busbar 78 is spaced apart from the first housing part 104 to prevent any electrical contact between them. The gaps between the laminated busbar 78 and the first housing part 106 must be filled by a dielectric material to ensure a hermetic seal.

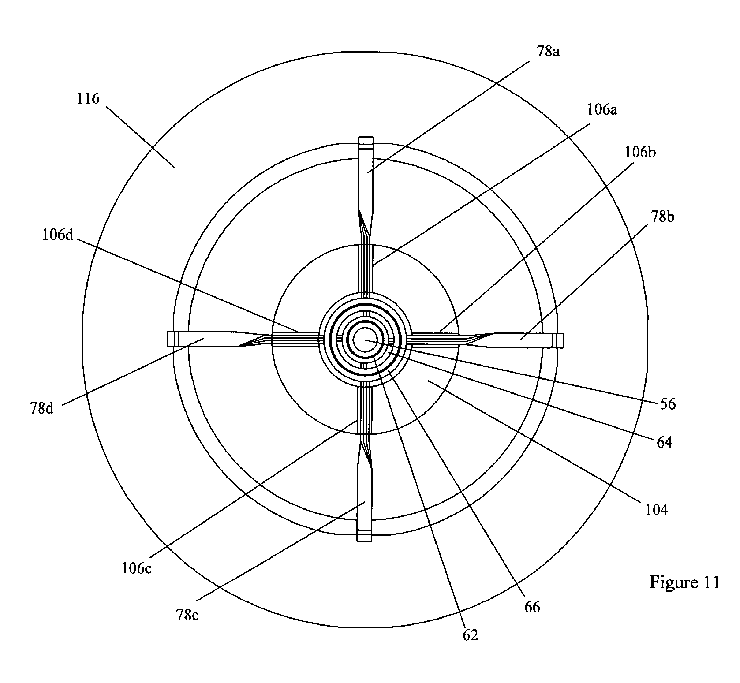

Figure 11 shows an alternative gate drive connection having four angularly spaced laminated busbars 78a-78d. Each laminated busbar 78a-78d is formed from a gate conductor element and an auxiliary cathode conductor element physically joined together by a strip of dielectric material as described above.

The auxiliary cathode contact 58 includes four slots through which a respective one of the gate conductor elements passes.

A radially inner part of each of the laminated busbars 78a-78d is received in a narrow slot 106a-106d provided in the first housing part 104. A radially outer part of each of the laminated busbars 78a-78d is twisted relative to the radially inner part by 90 degrees. The free end of each laminated busbar 78a-78d is connected to an annular PCB 116 that surrounds the first housing part 104 and on which the electronic components for four separate gate drive circuits are mounted. In other words, each laminated busbar 78a-78d is connected to its own individual gate drive circuit.

A gate drive connection having a plurality of laminated busbars such as that shown in Figure 11 will have a lower inductance than the gate drive connection 54 shown in Figures 4 to 10 which only has a single laminated busbar. It will be readily appreciated that providing multiple laminated busbar and gate drive circuits will increase the maximum gate current di/dt and hence allow higher device anode currents to be successfully controlled. The use of a plurality of laminated busbars and gate drive circuits to increase the current rating and reduce the leakage inductance of the gate drive connection shown in Figures 4 to 10 is equally applicable to the general arrangements shown in Figures 4 and 8. Whereas a single PCB 116 in Figure 11 may incorporate the functionality of a plurality of individual PCBs 70, the orientation of the PCB 70 shown in Figure 4 renders this impossible and in this case a plurality of PCBs 70 must be employed.

Both types of GTO gate drive circuit provide improvements as a result of the low leakage inductance of the gate drive connection 54, a reduction in the physical size of the overall device, thermal decoupling of the gate drive circuit components from the high temperatures experienced inside a conventional press pack construction and a corresponding increase in the reliability of the gate drive circuits and a reduction in the gate drive power supply loading.

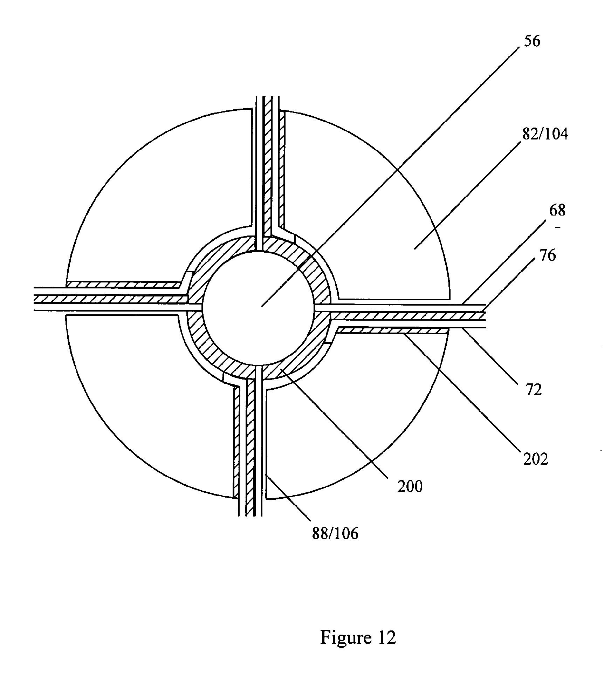

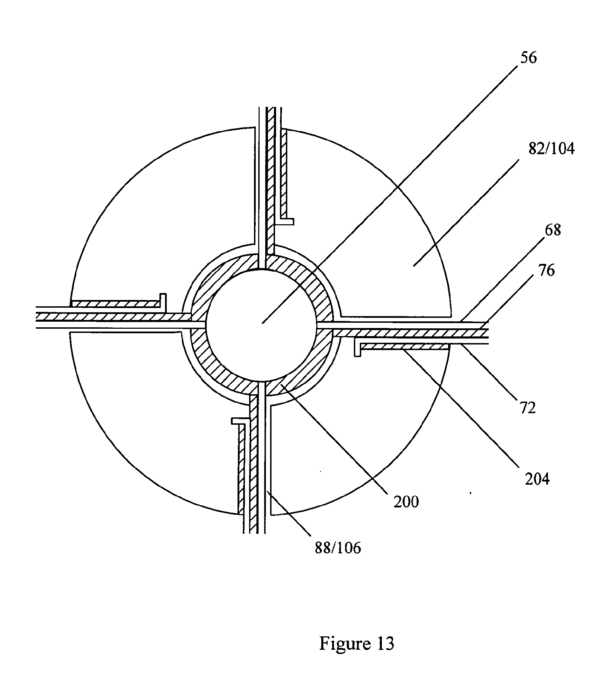

Figures 12 and 13 show simplified gate drive connections that can be employed with the GTO 40 having an "open" construction or the GTO 100 having a conventional press pack construction. In these gate drive connections, the auxiliary cathode contact is integrated or combined with the cathode side pole piece of the GTO which contacts the cathode plate 44. The need for a separate auxiliary cathode contact 58 and annular contact ring 66 is therefore avoided.

More particularly, Figure 12 shows a simplified gate drive connection where the auxiliary cathode connector element 72 of each laminated busbar 78 makes an electrical contact with the inner cylindrical surface of the first housing part 82, 104 that forms the cathode side pole piece. The electrical contact may be achieved by any convenient means such as ultrasonic welding, for example. An annular gap between the first housing part 82, 104 and the gate contact 56 may be filled with a dielectric material 200. The dielectric material 200 will also space the fixed end of the auxiliary cathode connector element 72 away from the gate contact 56. The gate connector element 68 of each laminated busbar 78 extends through the dielectric material 200 and is fixedly secured (e.g. soldered or brazed) to the outer cylindrical surface of the gate contact 56.

A layer of dielectric material 202 is also provided between the auxiliary cathode connector element 72 and the first housing part 82, 104 to ensure that the auxiliary cathode current is constrained to flow along the auxiliary cathode connector element and hence minimise inductance.

The gate drive connection shown in Figure 13 is similar but the auxiliary cathode connector element 72 of each laminated busbar 78 makes an electrical contact with a side of the slot 88, 106 in the first housing part 82, 104. A layer of dielectric material 204 is also provided between the auxiliary cathode connector element 72 and the first housing part 82, 104 to ensure that the auxiliary cathode current is constrained to flow along the auxiliary cathode connector element and hence minimise inductance.

## Claims

1. A semiconductor switching device (40;100) comprising:
a semiconductor body (42) having a cathode electrode and a gate electrode;
a cathode plate (44) in contact with the cathode electrode;
a gate drive circuit; and
a gate drive connection (54) having:
a gate connector in electrical contact with the gate electrode;
an auxiliary cathode connector in electrical contact with the cathode plate (44); and
a laminated strip conductor (78) comprising a first conductor element (68) along which a gate current can flow from the gate drive circuit to the gate connector, a second conductor element (72) along which an auxiliary cathode current can flow from the auxiliary cathode connector to the gate drive circuit, and a dielectric layer (76) between the first conductor element (68) and the second conductor element (72).

2. A semiconductor switching device (40;100) according to claim 1, wherein the first and second conductor elements (68, 72) of the laminated strip conductor (78) are thin strips of electrically conductive material that are physically joined together by a thin dielectric layer (76) such that they are closely coupled along a significant proportion of their length.

3. A semiconductor switching device (40;100) according to claim 1 or claim 2, wherein the gate connector includes a pressure contact member (56) and an annular contact ring (62) that is pressed into contact with the gate electrode.

4. A semiconductor switching device (40; 100) according to claim 3, wherein the auxiliary cathode connector includes a pressure contact member (58) and an annular contact ring (66) that is pressed into contact with the cathode plate (44).

5. A semiconductor switching device (40; 100) according to any preceding claim, wherein the gate connector is coaxially located within the auxiliary cathode connector.

6. A semiconductor switching device (40; 100) according to claim 4, wherein the pressure contact members (56, 58) are substantially annular, coaxially located and spaced apart by a dielectric layer (64).

7. A semiconductor switching device (40; 100) according to claim 3 or claim 4, wherein the gate connector extends through an aperture (46) provided in the cathode plate (44) so that the annular contact ring (62) of the gate connector is pressed into contact with the gate electrode.

8. A semiconductor switching device (40; 100) according to claim 7, wherein the annular contact ring (66) of the auxiliary cathode connector is pressed into contact with a region of the cathode plate (44) that borders the aperture (46).

9. A semiconductor switching device (40; 100) according to claim 3 or claim 4, wherein the first conductor element (68) of the laminated strip conductor (78) is fixed and electrically connected to an outer surface of the pressure contact member (56) of the gate connector.

10. A semiconductor switching device (40; 100) according to claim 3 or claim 4, wherein the first conductor element (68) of the laminated strip conductor (78) extends through a slot or opening (74) provided in the pressure contact member (58) of the auxiliary cathode connector.

11. A semiconductor switching device (40; 100) according to claim 3 or claim 4, wherein the second conductor element (72) of the laminated strip conductor (78) is fixed and electrically connected to an outer surface of the pressure contact member (58) of the auxiliary cathode connector.

12. A semiconductor switching device (40; 100) according to any of claims 1 to 3, wherein the auxiliary cathode connector is a cathode side pole piece.

13. A semiconductor switching device (40; 100) according to claim 12, wherein the second conductor element (72) of the laminated strip conductor (78) is fixed and electrically connected to an inner surface of the cathode side pole piece.

14. A semiconductor switching device (40; 100) according to any preceding claim, wherein the laminated strip conductor (78) extends substantially radially.

15. A semiconductor switching device (40; 100) according to any preceding claim, wherein the laminated strip conductor (78) is flexible.

16. A semiconductor switching device (40; 100) according to any preceding claim, further comprising a housing (82; 104) having an aperture or opening (80; 102) for receiving the gate and auxiliary cathode connectors and a slot (88; 106) for receiving the laminated strip conductor (78).

17. A semiconductor switching device (40) according to claim 16, having an open construction and where the housing (82) is a heatsink that includes a plurality of cooling fins (92).

18. A semiconductor switching device (100) according to claim 16, wherein the housing (104) is a cathode side pole piece for a press pack construction.

19. A semiconductor switching device (40; 100) according to any preceding claim, wherein the gate drive connection (54) includes a plurality of laminated strip conductors (78).

20. A semiconductor switching device (40; 100) according to claim 19, wherein the plurality of laminated strip conductors (78) are angularly spaced around the gate drive connection (54).
